# DEMANDE DE BREVET EUROPEEN

(11) **EP 4 848 973 A1**
(43) Date de publication de la demande: **02.12.2026**
(21) Numéro de dépôt: 26179788.0
(22) Date de dépôt: 20.05.2026
(51) Int. Cl.: H10W 70/60

(54) **PROCÉDÉ D ASSEMBLAGE DE PUCE SUR UN SUBSTRAT**

(30) Priorité: 27.05.2025 FR 2505696
(71) Demandeur: Commissariat à l'Energie Atomique et aux Energies Alternatives, 75015 Paris (FR)
(72) Inventeur: BOURJOT, Emilie, 38054 Grenoble cedex 09 (FR); NAJEM, Mélissa, 38054 Grenoble cedex 09 (FR); CHARBONNIER, Jean, 38054 Grenoble cedex 09 (FR)
(74) Mandataire: Hautier IP

(57) **Abrégé**

L'invention porte sur un procédé d'assemblage de puce (20) sur un substrat (10) par collage hybride direct comprenant, après collage :
• Un amincissement de la puce (20) à partir d'une première face arrière (220),
• Une encapsulation de la puce amincie (20, 20a) par une couche d'encapsulation (31),
• Un amincissement du substrat (10) à partir d'une deuxième face arrière (120),
• Une formation de vias de connexion (50) traversant le substrat aminci (10, 10a) depuis la deuxième face arrière (120), lesdits vias de connexion (50) étant connectés aux interconnexions métalliques (12) du substrat (10).

## Description

### DOMAINE TECHNIQUE

La présente invention concerne le domaine des technologies de la microélectronique. Elle trouve une application particulièrement avantageuse dans les procédés de report ou d'assemblage de puce électronique sur un substrat, appelés « die to wafer ».

### ETAT DE LA TECHNIQUE

Pour répondre aux besoins croissants en densité d'interconnexions entre une puce et un support de puce, plusieurs solutions sont développées. L'intégration hétérogène consiste à reporter une puce sur un support présentant lui-même une densité d'interconnexions et une résolution élevées, typiquement un interposeur à base de silicium fabriqué en technologie CMOS (signifiant « transistors complémentaires métal-oxyde-semiconducteur »). Ce type d'intégration est particulièrement intéressant pour l'industrie, car il permet d'assembler différents nœuds technologiques sur un même interposeur. L'assemblage de la puce avec l'interposeur peut avantageusement se faire par collage hybride. La densité d'interconnexions ainsi obtenue entre la puce et l'interposeur, dont le pas d'interconnexion est typiquement inférieur à 10 µm, est significativement plus élevée que les densités d'interconnexions atteignables par d'autres techniques d'assemblage connues sous les dénominations « wire bonding » (signifiant « connexion filaire ») et « micro-bump » (signifiant « micro-sphère »), pour lesquelles les pas d'interconnexion sont typiquement supérieurs à 40 µm. Cela permet d'atteindre une fréquence de communication avantageusement élevée entre la puce et l'interposeur.

Il est néanmoins nécessaire de prévoir des plots de contact sur l'interposeur pour interfacer l'assemblage puce/interposeur avec d'autres dispositifs, typiquement pour connecter les entrées / sorties correspondantes. Ces plots de contact peuvent être réalisés en face avant de l'interposeur, de chaque côté de la puce par exemple. Cela permet par exemple d'envisager une connexion filaire en face avant. La conception des plots de contact en face avant de l'interposeur diminue cependant la surface disponible pour assembler d'autres éléments, par exemple d'autres puces, sur l'interposeur. Par ailleurs, l'intégration des plots de contact en face avant de l'interposeur augmente le risque de défectivité lors du collage hybride.

Une autre solution divulguée par le document « Enabling Next Generation 3D Heterogeneous Integration Architectures on Intel Process, A. Elsherbini et al., IEDM 2022 » consiste à reporter des plots de contact en face arrière du substrat. Le substrat comprend ici plusieurs puces intégrées dans une matrice diélectrique. Des vias de connexion sont formés de manière à traverser la matrice diélectrique pour connecter directement la ou les puces en face avant du substrat. Cette solution reste complexe à mettre en œuvre. Le polissage et/ou la préparation de la face arrière comprenant des portions de matrice diélectrique et des portions de puces est délicat. La gestion de différents types de vias de connexion à travers la matrice diélectrique et à travers les puces augmente également le coût et la durée du procédé d'assemblage.

Il existe donc un besoin pour un procédé de report ou d'assemblage de puce électronique sur un substrat, répondant aux besoins de fortes densités d'interconnexions et présentant un coût limité et/ou une fiabilité améliorée.

Un objectif de l'invention est de répondre à ce besoin, et de pallier au moins en partie les inconvénients des solutions connues.

En particulier, un objet de l'invention est un procédé d'assemblage de puce sur un substrat permettant une intégration améliorée tout en limitant le coût du procédé. Un autre objet de l'invention concerne un assemblage obtenu par un tel procédé.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un premier aspect on prévoit un procédé d'assemblage de puce sur un substrat comprenant :
- Une fourniture d'un assemblage comprenant une puce et un substrat, ladite puce comprenant une première couche d'oxyde et des premières interconnexions métalliques débouchant sur une face de la première couche d'oxyde, dite première face avant, le substrat comprenant une deuxième couche d'oxyde et des deuxièmes interconnexions métalliques débouchant sur une face de la deuxième couche d'oxyde, dite deuxième face avant, le substrat et la puce étant assemblés par collage au niveau des première et deuxième faces avant,
- Un amincissement de la puce à partir d'une face exposée de la puce opposée à la première face avant, dite première face arrière,
- Une encapsulation de la puce amincie par une couche d'encapsulation s'étendant sur la deuxième face avant, autour de la puce et sur la première face arrière, ladite couche d'encapsulation présentant une face plane, dite face de manipulation,
- Un amincissement du substrat à partir d'une face exposée du substrat opposée à la deuxième face avant, dite deuxième face arrière,
- Une formation de vias de connexion traversant le substrat aminci depuis la deuxième face arrière, lesdits vias de connexion étant connectés aux deuxièmes interconnexions métalliques,
- Au moins une étape technologique ultérieure sur les vias de connexion, au niveau de la deuxième face arrière.

En formant des vias de connexion débouchant sur la deuxième face arrière, le procédé permet avantageusement d'augmenter la surface utile sur la deuxième face avant, par exemple pour l'intégration d'une autre puce.

Par ailleurs, la surface disponible sur la deuxième face arrière étant relativement importante, ce procédé permet d'augmenter les possibilités pour le routage des niveaux d'interconnexions du substrat, et/ou pour des couches dites de redistribution sur la deuxième face arrière.

Le procédé évite également la formation de plots de contact sur la deuxième face avant du substrat. Ces plots de contact, dont les dimensions sont significativement supérieures aux dimensions des deuxièmes interconnexions métalliques, peuvent, s'ils sont présents, entraîner des difficultés lors de la préparation de surface de la deuxième face avant en vue du collage de la puce sur le substrat. Par suite, le taux de défectivité du collage peut augmenter. A contrario, le procédé selon l'invention supprime avantageusement la nécessité d'avoir des plots de contact sur la deuxième face avant du substrat. La préparation de surface de la deuxième face avant est ainsi améliorée. Le collage hybride entre la puce et le substrat est amélioré et le taux de défectivité est diminué.

Là encore, la surface disponible sur la deuxième face arrière étant relativement importante, en formant des plots de contact connectant les vias de connexion au niveau de la deuxième face arrière, la densité de ces plots de contact peut être augmentée.

Le substrat, qui se présente typiquement sous la forme d'un interposeur à base de silicium, peut ensuite être connecté au niveau de la deuxième face arrière, en particulier sur des plots de contact formés sur la deuxième face arrière, par une technique du type « micro-bump » par exemple. Le coût du procédé est ainsi limité.

Par ailleurs, les vias de connexions formés en face arrière du substrat aminci permettent avantageusement de réaliser des interconnexions de faibles longueurs, typiquement inférieures à 10 µm, avec la ou les puces reportées. Cela permet de diminuer ou de limiter les parasites de type (R,L,C). Les performances du dispositif formé peuvent être significativement améliorées.

Le procédé selon l'invention, en particulier l'amincissement de la puce avant encapsulation et la formation des TSV après amincissement du substrat, procure des avantages techniques substantiels par rapport aux procédés de l'état de la technique.

L'amincissement de la puce avant l'encapsulation permet de réduire la quantité de matériau d'encapsulation nécessaire, ce qui optimise les coûts. De plus, cela permet de mieux maîtriser la contrainte mécanique et la flèche du substrat, qui peuvent être induites par des couches d'encapsulant épaisses. La planarisation de surface par CMP est également mieux contrôlée.

La formation des TSV après l'amincissement du substrat supprime les difficultés liées à l'amincissement d'un substrat contenant déjà des vias, notamment le risque de déformation ou de rupture des vias fins, et garantit une surface parfaitement plane et stable pour la fabrication des TSV et pour d'éventuelles étapes de collage moléculaire ou hybride ultérieures. Le contrôle de la hauteur des TSV est également amélioré, ce qui est particulièrement avantageux pour obtenir une faible variation d'épaisseur totale (TTV) compatible avec les technologies de photolithographie avancées.

Un autre aspect de l'invention concerne un dispositif comprenant une puce et un substrat assemblés entre eux, ladite puce comprenant une première couche d'oxyde et des premières interconnexions métalliques débouchant sur une face de la première couche d'oxyde, dite première face avant, le substrat comprenant une deuxième couche d'oxyde et des deuxièmes interconnexions métalliques débouchant sur une face de la deuxième couche d'oxyde, dite deuxième face avant, le substrat et la puce étant assemblés par collage au niveau des première et deuxième faces avant, le dispositif comprenant en outre :
- une couche d'encapsulation s'étendant sur la deuxième face avant, et sur une première face arrière de la puce opposée à la première face avant, ladite couche d'encapsulation présentant une face plane, dite face de manipulation,
- une plaque dite de manipulation sur la face de manipulation,
- des vias de connexion traversant le substrat depuis une deuxième face arrière opposée à la deuxième face avant, lesdits vias de connexion étant connectés aux deuxièmes interconnexions métalliques.

Avantageusement, le substrat comprend une couche semiconductrice et les vias de connexion traversent ladite couche semiconductrice. Le substrat se présente typiquement sous la forme d'un interposeur à base de silicium.

Les avantages indiqués précédemment en référence au procédé, sont applicables mutatis mutandis au dispositif de l'invention.

### BREVE DESCRIPTION DES FIGURES

Les buts, objets, ainsi que les caractéristiques et avantages de l'invention ressortiront mieux de la description détaillée de certains modes de réalisation de cette dernière, qui sont illustrés par les dessins d'accompagnement suivants dans lesquels :
Les figures 1 à 9 illustrent schématiquement en vue transverse des étapes de fabrication d'un assemblage « die to wafer », selon un mode de réalisation de la présente invention.
Les figures 10 et 13 illustrent schématiquement en vue transverse des étapes de fabrication d'un assemblage « die to wafer », selon un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs et/ou les dimensions des différentes couches, motifs et reliefs ne sont pas représentatives de la réalité. Pour des raisons de clarté, l'ensemble des références alphanumériques n'est pas systématiquement repris d'une figure à l'autre. Il est entendu que les éléments déjà décrits et référencés, lorsqu'ils sont reproduits sur une autre figure, portent typiquement les mêmes références alphanumériques, même si celles-ci ne sont pas explicitement mentionnées. L'homme du métier identifiera sans difficultés un même élément reproduit sur différentes figures.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le procédé comprend en outre, après encapsulation, un collage d'une plaque dite de manipulation sur la face de manipulation, et un retrait partiel de la plaque de manipulation après l'au moins une étape technologique ultérieure. La plaque de manipulation permet typiquement de manipuler l'assemblage « die to wafer » de façon à effectuer une ou plusieurs étapes technologiques du côté de la deuxième face arrière (celle du substrat). Elle peut être amincie de façon à rester manipulable par des automates d'équipements industriels, typiquement en conservant une épaisseur de l'ordre de 320 µm.

Selon un exemple, l'au moins une étape technologique ultérieure comprend une formation de contacts électriques sur les vias de connexion. Ces contacts électriques peuvent se présenter sous la forme d'une couche dite de redistribution formée sur la deuxième face arrière.

Selon un exemple, l'au moins une étape technologique ultérieure comprend en outre, après formation des contacts électriques sur les vias de connexion, une formation de billes de soudure sur les contacts électriques. Le procédé selon l'invention est avantageusement compatible avec des techniques du type « micro-bump ».

Selon un exemple, le substrat aminci présente une épaisseur inférieure à 10 µm, par exemple de l'ordre de 5 µm.

Selon un exemple, la puce amincie présente une épaisseur inférieure à 15 µm, par exemple de l'ordre de 8 µm. Selon un exemple, la couche d'encapsulation présente une épaisseur inférieure à 30 µm, par exemple de l'ordre de 25 µm.

Selon un exemple, le substrat comprend une partie dite épaisse sous la deuxième couche d'oxyde et les deuxièmes interconnexions métalliques, l'amincissement du substrat étant configuré pour retirer partiellement cette partie épaisse, et ladite partie épaisse comprend au moins une interface configurée pour détecter une fin d'amincissement lors de l'amincissement du substrat. La présence de cette interface dite de détection de fin d'amincissement facilite le contrôle de l'étape d'amincissement.

Selon un exemple, la partie épaisse du substrat est de type semiconducteur sur isolant (SOI) et comprend en empilement une couche massive à base de silicium, une couche d'oxyde enterrée et une couche semiconductrice dite superficielle. Le substrat peut être du type silicium sur isolant ou germanium sur isolant ou encore silicium-germanium sur isolant, selon la nature de la couche semiconductrice superficielle.

Selon un exemple, l'au moins une interface de détection de fin d'amincissement correspond à l'interface entre la couche massive et la couche d'oxyde enterrée.

Selon un exemple, la partie épaisse du substrat comprend au moins deux couches semiconductrices présentant entre elles un contraste de dopage. Selon un exemple, l'au moins une interface de détection de fin d'amincissement correspond à l'interface entre ces deux couches semiconductrices.

Selon un exemple, l'au moins une étape technologique ultérieure comprend un collage direct d'une couche de circuit intégré sur la deuxième face arrière. Ce type d'étape technologique requiert une grande qualité de surface pour la deuxième face arrière. L'utilisation d'un substrat de type SOI aminci jusqu'à la couche d'oxyde enterrée permet avantageusement d'obtenir une telle qualité de surface pour la deuxième face arrière.

Selon un exemple, l'au moins une étape technologique ultérieure comprend une étape de lithographie en UV profond, avec un rayonnement de longueur d'onde inférieure à 250 nm. Ce type d'étape technologique requiert également une grande qualité de surface pour la deuxième face arrière. L'utilisation d'un substrat de type SOI aminci jusqu'à la couche d'oxyde enterrée permet avantageusement d'obtenir une telle qualité de surface pour la deuxième face arrière.

Selon un exemple, le substrat aminci comprend une couche semiconductrice et les vias de connexion traversent ladite couche semiconductrice.

Selon un exemple, le substrat aminci comprend une couche d'oxyde sur la couche semiconductrice, au niveau de la deuxième face arrière, et les vias de connexion traversent ladite couche d'oxyde. Cette couche d'oxyde peut être formée après amincissement d'un substrat massif à base de silicium par exemple. Elle peut alternativement correspondre à une couche d'oxyde enterrée d'un substrat de type SOI, qui est exposée après amincissement du substrat.

Selon un exemple, les vias de connexion sont des vias dits à haute densité (TSV HD). Dans ce contexte, les vias de connexion présentent typiquement un diamètre inférieur à 2 µm et une hauteur inférieure à 20 µm. Le pas minimal entre deux vias de connexion voisins peut avantageusement être inférieur à 5 µm. La formation de tels TSV HD est rendue possible par le procédé de l'invention où le substrat est d'abord aminci jusqu'à une épaisseur de quelques micromètres, présentant une surface de haute planéité, avant la formation desdits vias.

Selon un exemple, les vias de connexion sont connectés à une couche de circuit intégré comprenant des transistors complémentaires métal-oxyde-semiconducteur (MOS). Ces transistors MOS sont typiquement formés à basse température. Ils sont parfois appelés « MOS froids ».

Selon un exemple, les vias de connexion sont connectés à une couche de photonique sur silicium soit reportée soit directement formée sur lesdits vias de connexion. Une telle couche comprend typiquement des dispositifs photoniques couplés par des guides d'onde. Cela permet de réaliser des systèmes appelés « Optical Network on Chip » (ONoC).

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques et les avantages d'un aspect de l'invention, par exemple l'assemblage « die to wafer » avec connexions en face arrière du wafer ou le procédé de réalisation de ces connexions, peuvent être adaptés *mutatis mutandis* à un autre aspect de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

Un repère de préférence orthonormé, comprenant les axes x, y, z est représenté sur les figures annexées.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche d'alumine poreuse présente typiquement une épaisseur selon z. une paroi ou un pore présente une hauteur selon z. Les termes relatifs « sur », « surmonte », « sous », « sous-jacent » se réfèrent à des positions prises selon la direction z.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

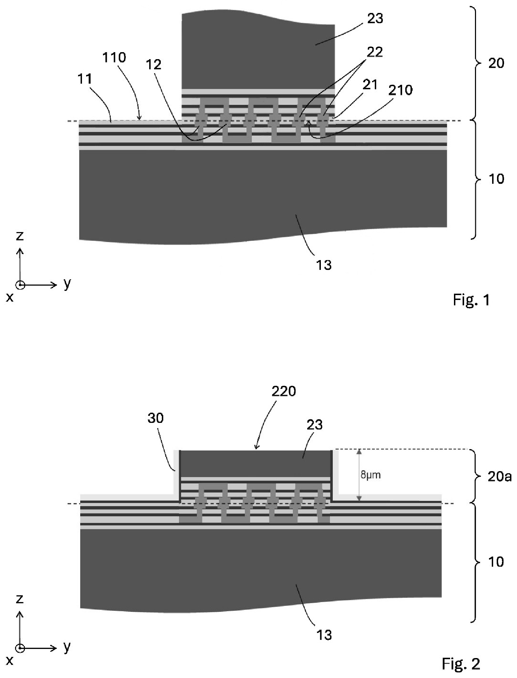

Les figures 1 à 9 illustrent schématiquement en coupe transverse un premier procédé de fabrication de connexions en face arrière d'un assemblage « die to wafer ».

Comme illustré à la figure 1, une puce 20 est d'abord assemblée à un substrat 10, typiquement par collage hybride direct.

La puce 20 comprend typiquement une partie massive 23, par exemple à base de silicium, au moins une couche d'oxyde 21 du côté de sa face avant 210 et au moins des interconnexions métalliques 22 débouchant au niveau de la face avant 210. Comme illustré sur les figures, dans cet exemple, la puce 20 comprend également plusieurs couches entre la couche d'oxyde 21 et la partie massive 23. Ces différentes couches peuvent correspondre de façon classique à différents niveaux de métaux formés par des procédés dits de fin de ligne BEOL (acronyme de « Back End Of Line ») et/ou à des couches actives formées par des procédés dits de début de ligne FEOL (acronyme de « Front End Of Line »). La partie massive 23 peut présenter une épaisseur de plusieurs centaines de micromètres, typiquement de l'ordre de 775 µm pour une puce 20 issue d'un wafer à base de silicium.

Le substrat 10 comprend typiquement une partie massive 13, par exemple à base de silicium, au moins une couche d'oxyde 11 du côté de sa face avant 110 et au moins des interconnexions métalliques 12 débouchant au niveau de la face avant 110. Comme illustré sur les figures, dans cet exemple, le substrat 10 comprend également plusieurs couches entre la couche d'oxyde 11 et la partie massive 13. Ces différentes couches peuvent correspondre de façon classique à différents niveaux de métaux formés par des procédés dits de fin de ligne BEOL (acronyme de « Back End Of Line ») et/ou à des couches actives formées par des procédés dits de début de ligne FEOL (acronyme de « Front End Of Line »). En particulier, lorsque le substrat 10 est destiné à former un interposeur pour une ou plusieurs puces, ces différentes couches peuvent former un ou des circuits de routage électrique configurés pour gérer les entrées / sorties électriques vers les différentes puces. La partie massive 13 peut présenter une épaisseur de plusieurs centaines de micromètres, typiquement de l'ordre de 775 µm pour un substrat sous forme de wafer à base de silicium.

L'assemblage entre la puce 20 et le substrat 10 peut s'effectuer par collage hybride direct, qui comprend de façon connue une mise en contact de la face avant 110 du substrat 10 avec la face avant 210 de la puce 20. Les portions exposées des interconnexions métalliques 12 sont alignées avec les portions exposées des interconnexions métalliques 22, et les portions exposées de couche d'oxyde 11 sont alignées avec les portions exposées de couche d'oxyde 21. La figure 1 illustre schématiquement l'assemblage obtenu après collage.

Comme illustré à la figure 2, la puce 20 est ensuite amincie à partir de la face arrière 220. Cet amincissement peut typiquement se faire par rognage et/ou polissage de la partie massive 23 de la puce 20. Cet amincissement peut requérir des étapes intermédiaires de dépôt d'une ou plusieurs couches 30, par exemple pour protéger les flancs de la puce 20 et/ou la surface de la face avant 110. Selon un exemple, l'amincissement se fait selon les procédés divulgués dans le document FR2307330. Après amincissement, la puce 20a présente typiquement une hauteur de l'ordre de quelques micromètres à quelques dizaines de micromètres, par exemple environ 8 µm.

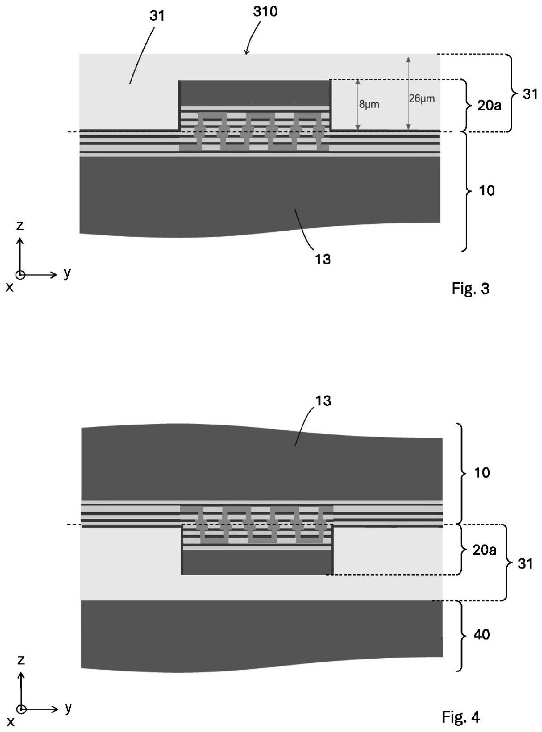

Comme illustré à la figure 3, la puce amincie 20a est ensuite encapsulée dans une ou plusieurs couches d'encapsulation 31 diélectriques, par exemple à base d'oxyde de silicium. La couche d'encapsulation 31 présente une épaisseur supérieure à la hauteur de la puce amincie 20a, par exemple environ 26 µm, de façon à couvrir les flancs et la face arrière 220 de la puce 20a. La couche d'encapsulation 31 couvre également la face avant 110 du substrat 10. La couche d'encapsulation 31 est planarisée, typiquement par polissage mécano-chimique (CMP), afin de présenter une face de manipulation 310 plane.

Comme illustré à la figure 4, l'assemblage substrat / puce encapsulée est de préférence retourné et reporté sur une plaque de manipulation 40, par exemple un wafer à base de silicium, en vue de l'amincissement du substrat 10. Ce report peut se faire par collage direct entre la face de manipulation 310 et la surface de la plaque de manipulation 40.

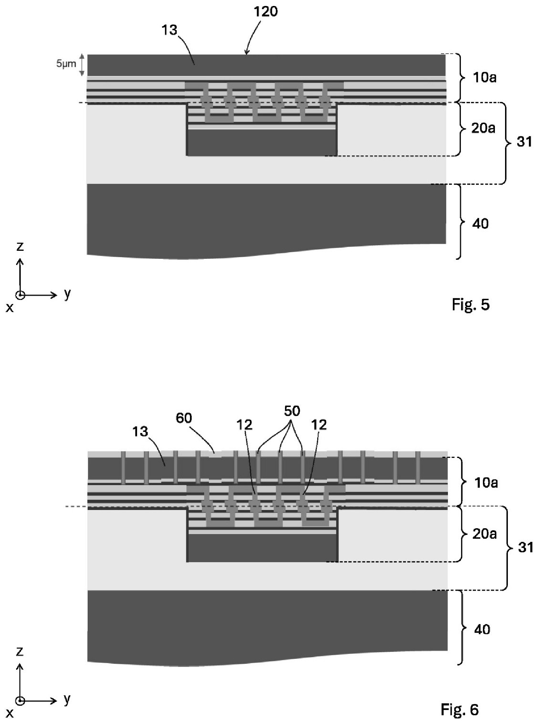

Comme illustré à la figure 5, la partie massive 13 du substrat 10 est ensuite amincie à partir de la face arrière 120. Cet amincissement peut typiquement se faire par rognage et/ou polissage de la partie massive 13 du substrat 10. Après amincissement, la partie massive 13 du substrat 10a présente typiquement une hauteur de l'ordre de quelques micromètres à quelques dizaines de micromètres, par exemple environ 5 µm.

Comme illustré à la figure 6, l'amincissement du substrat 10a permet avantageusement de former des vias de connexion 50 au travers du substrat 10a. Dans cet exemple, une couche d'oxyde 60 est typiquement formée sur la face arrière 120 du substrat aminci 10a. Une étape de lithographie permet ensuite de définir des motifs de vias de connexion sur cette couche d'oxyde 60. Ces motifs de vias de connexion sont de préférence denses, par exemple avec un pas minimal de l'ordre de 5 µm entre deux motifs de vias voisins. Le support offert par la plaque de manipulation 40 permet typiquement de faciliter cette étape de lithographie. La résolution de lithographie peut être optimisée. Après gravure sur toute l'épaisseur de la couche semiconductrice 13 jusqu'aux interconnexions métalliques 12, les motifs de vias sont remplis de façon à former les vias de connexion 50 connectant les interconnexions métalliques 12.

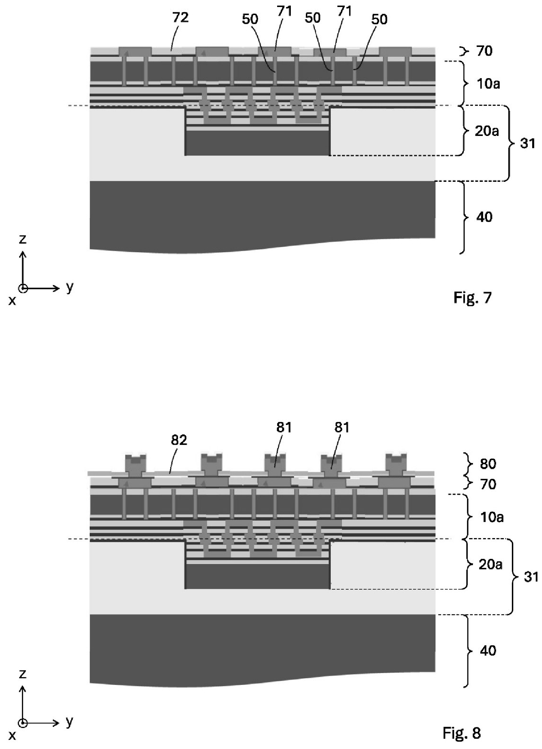

Comme illustré à la figure 7, des plots de contact 71 peuvent ensuite être formés en face arrière, sur les vias de connexion 50. Ces plots de contact 71 sont typiquement formés au sein d'une couche de redistribution 70 comprenant des portions diélectriques 72 entre les plots de contact 71.

Comme illustré à la figure 8, selon une possibilité, des « micro-bumps » 81, définis par l'intermédiaire d'une couche diélectrique 82, peuvent être ensuite formés sur les plots de contact 71. Cette couche de connexion 80 comprenant des micro-bumps 81 peut être envisagée en fonction des applications visées.

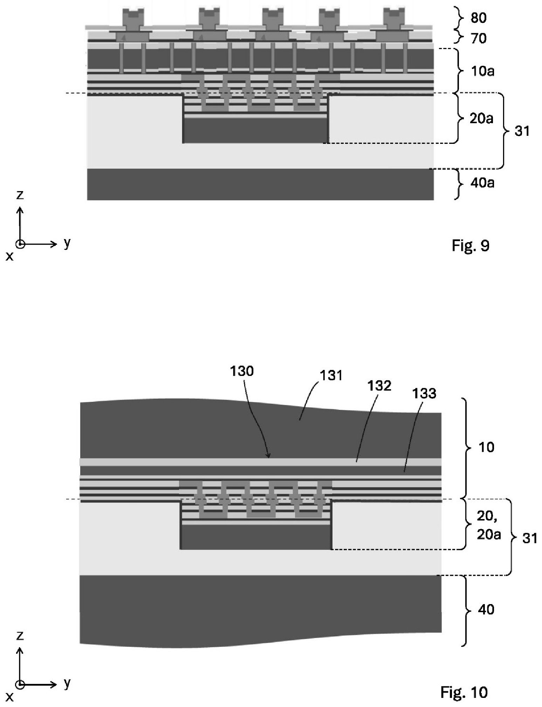

Comme illustré à la figure 9, la plaque de manipulation 40 est de préférence amincie par la suite, par exemple par rognage et/ou polissage. La plaque de manipulation amincie 40a présente de préférence une épaisseur de l'ordre de 320 µm de façon à ce que l'ensemble comprenant la plaque 40a et l'assemblage puce 20a sur substrat 10a puisse être manipulé par des équipements automatisés des technologies de la microélectronique.

Les figures 10 à 13 illustrent schématiquement en coupe transverse un deuxième procédé de fabrication de connexions en face arrière d'un assemblage « die to wafer ». Seules les caractéristiques qui diffèrent du procédé décrit précédemment sont illustrées et décrites dans la suite, les autres caractéristiques étant réputées identiques.

Comme illustré à la figure 10, la puce 20 a été assemblée dans cet exemple à un substrat 10 de type SOI, comprenant typiquement une couche massive 131 à base de silicium, une couche d'oxyde enterrée 132 et une couche semiconductrice superficielle 133. Après assemblage, la puce 20a est amincie puis encapsulée dans la couche d'encapsulation 31, avant d'être reportée sur la plaque de manipulation 40, comme précédemment.

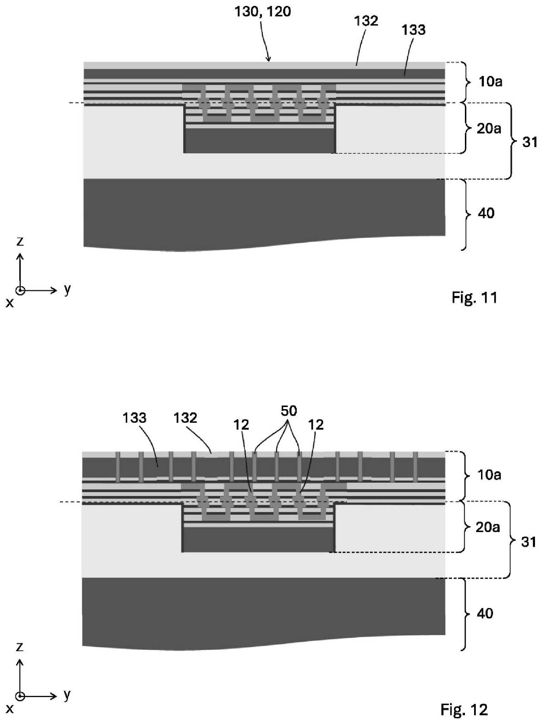

Comme illustré à la figure 11, la partie massive 131 du substrat 10 peut ensuite être retirée à partir de la face arrière 120. Cet amincissement peut typiquement se faire en partie par rognage et/ou polissage dans un premier temps, puis en partie par voie chimique dans un deuxième temps de façon à contrôler précisément l'arrêt de l'amincissement au niveau de l'interface 130 entre la couche massive 131 et la couche d'oxyde enterrée 132. Cette interface 130 forme un contraste de matériaux qui est avantageusement exploité comme détection de fin de gravure lors de la gravure chimique sélective de la couche massive 131 vis-à-vis de la couche d'oxyde enterrée 132. L'interface 130 peut également être exploitée comme détection de fin d'amincissement lors du polissage CMP de la couche massive 131. L'interface 130 ainsi exposée présente avantageusement une planéité améliorée. En particulier, la variation totale d'épaisseur TTV (acronyme de « Total Thickness Variation »), à l'échelle du wafer, peut être significativement réduite. Cela permet d'envisager des étapes technologiques ultérieures, au niveau de la face arrière 120, requérant un état de surface parfaitement contrôlé, notamment en termes de planéité et de rugosité.

Comme illustré à la figure 12, des vias de connexion 50 peuvent ensuite être avantageusement formés au travers du substrat aminci 10a. Dans cet exemple, le substrat aminci 10a comprend la couche semiconductrice superficielle 133 et la couche d'oxyde enterrée 132. Avantageusement, l'étape de lithographie permettant de définir les motifs de vias de connexion sur la couche d'oxyde enterrée 132 peut ici être mise en œuvre en utilisant un rayonnement UV profond, présentant typiquement une longueur d'onde inférieure à 250 nm. Cela permet d'améliorer la résolution de définition des motifs de vias de connexion. La densité des motifs de vias de connexion peut être augmentée. La mise en œuvre d'une lithographie de type UV profond requiert typiquement un état de surface parfaitement contrôlé, notamment en termes de planéité et de rugosité. L'amincissement du substrat 10 jusqu'à l'interface 130 est ici configuré de façon à obtenir un tel état de surface.

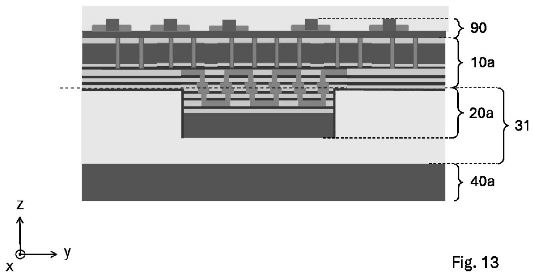

Comme illustré à la figure 13, le procédé peut être poursuivi par la formation d'une couche 90 de circuit intégré sur la face arrière 120. Cette couche 90 de circuit intégré peut typiquement comprendre des transistors MOS complémentaires. La couche 90 est par exemple formée à basse température, typiquement inférieure ou égale à 400°C, directement en face arrière 120. Alternativement, elle peut être formée séparément et reportée par collage direct sur la face arrière 120. La mise en œuvre d'un collage direct requiert typiquement un état de surface parfaitement contrôlé, notamment en termes de planéité et de rugosité. L'amincissement du substrat 10 jusqu'à l'interface 130 est ici configuré de façon à obtenir un tel état de surface. D'autres couches peuvent avantageusement être formées ou reportées par collage direct sur la face arrière 120, en fonction des applications visées.

Au vu de la description qui précède, il apparaît que les procédés proposés offrent une solution pour former des connexions en face arrière d'un interposeur supportant une ou plusieurs puces, qui est particulièrement efficace et compatible avec les procédés de l'industrie de la microélectronique. L'invention n'est pas limitée aux modes de réalisations précédemment décrits. D'autres substrats sont possibles, en particulier pour mettre en œuvre l'amincissement du substrat avec une détection de fin d'amincissement parfaitement contrôlée. Des substrats comprenant différentes couches semiconductrices présentant un contraste de dopage entre elles peuvent notamment être utilisés.

## Revendications

1. Procédé d'assemblage de puce (20) sur un substrat (10) comprenant :
• Une fourniture d'un assemblage comprenant une puce (20) et un substrat (10), ladite puce (20) comprenant une première couche d'oxyde (21) et des premières interconnexions métalliques (22) débouchant sur une face (210) de la première couche d'oxyde (21), dite première face avant (210), le substrat (10) comprenant une deuxième couche d'oxyde (11) et des deuxièmes interconnexions métalliques (12) débouchant sur une face (110) de la deuxième couche d'oxyde (11), dite deuxième face avant (110), le substrat (10) et la puce (20) étant assemblés par collage au niveau des première et deuxième faces avant (210, 110),
• Un amincissement de la puce (20) à partir d'une face (220) exposée de la puce (20) opposée à la première face avant (210), dite première face arrière (220),
• Une encapsulation de la puce amincie (20, 20a) par une couche d'encapsulation (31) s'étendant sur la deuxième face avant (110), autour de la puce (20, 20a) et sur la première face arrière (220), ladite couche d'encapsulation (31) présentant une face (310) plane, dite face de manipulation (310),
• Un amincissement du substrat (10) à partir d'une face (120) exposée du substrat (10) opposée à la deuxième face avant (110), dite deuxième face arrière (120),
• Une formation de vias de connexion (50) traversant le substrat aminci (10, 10a) depuis la deuxième face arrière (120), lesdits vias de connexion (50) étant connectés aux deuxièmes interconnexions métalliques (12),
• Au moins une étape technologique ultérieure sur les vias de connexion (50), au niveau de la deuxième face arrière (120).

2. Procédé selon la revendication précédente comprenant en outre, après encapsulation, un collage d'une plaque (40) dite de manipulation sur la face de manipulation (310), et un retrait partiel de la plaque de manipulation (40, 40a) après l'au moins une étape technologique ultérieure.

3. Procédé selon l'une quelconque des revendications précédentes dans lequel l'au moins une étape technologique ultérieure comprend une formation de contacts électriques (71) sur les vias de connexion (50).

4. Procédé selon la revendication précédente dans lequel l'au moins une étape technologique ultérieure comprend en outre, après formation des contacts électriques (71) sur les vias de connexion (50), une formation de billes de soudure (81) sur les contacts électriques (71).

5. Procédé selon l'une quelconque des revendications précédentes dans lequel le substrat aminci (10a) présente une épaisseur inférieure à 10 µm.

6. Procédé selon l'une quelconque des revendications précédentes dans lequel la puce amincie (20a) présente une épaisseur inférieure à 15 µm, et dans lequel la couche d'encapsulation (31) présente une épaisseur inférieure à 30 µm.

7. Procédé selon l'une quelconque des revendications précédentes dans lequel le substrat (10) comprend une partie (13) dite épaisse sous la deuxième couche d'oxyde (11) et les deuxièmes interconnexions métalliques (12), l'amincissement du substrat (10) étant configuré pour retirer partiellement cette partie épaisse (13), et dans lequel ladite partie épaisse (13) comprend au moins une interface (130) configurée pour détecter une fin d'amincissement lors de l'amincissement du substrat (10).

8. Procédé selon la revendication précédente dans lequel la partie épaisse (13) du substrat est de type semiconducteur sur isolant et comprend en empilement une couche massive à base de silicium (131), une couche d'oxyde enterrée (132) et une couche semiconductrice (133) dite superficielle, et dans lequel l'au moins une interface (130) de détection de fin d'amincissement correspond à l'interface entre la couche massive (131) et la couche d'oxyde enterrée (132).

9. Procédé selon la revendication 7 dans lequel la partie épaisse (13) du substrat comprend au moins deux couches semiconductrices présentant entre elles un contraste de dopage, et dans lequel l'au moins une interface (130) de détection de fin d'amincissement correspond à l'interface entre ces deux couches semiconductrices.

10. Procédé selon l'une quelconque des revendications 7 à 10 dans lequel l'au moins une étape technologique ultérieure comprend un collage direct d'une couche (90) de circuit intégré sur la deuxième face arrière (120).

11. Procédé selon l'une quelconque des revendications 7 à 10 dans lequel l'au moins une étape technologique ultérieure comprend une étape de lithographie en UV profond, avec un rayonnement de longueur d'onde inférieure à 250 nm.

12. Procédé selon l'une quelconque des revendications précédentes dans lequel le substrat aminci (10a) comprend une couche semiconductrice (13, 133) et dans lequel les vias de connexion (50) traversent ladite couche semiconductrice (13, 133).

13. Procédé selon la revendication précédente dans lequel le substrat aminci (10a) comprend une couche d'oxyde (60, 132) sur la couche semiconductrice (13, 133), au niveau de la deuxième face arrière (120), et dans lequel les vias de connexion (50) traversent ladite couche d'oxyde (60, 132).

14. Dispositif comprenant une puce (20, 20a) et un substrat (10, 10a) assemblés entre eux, ladite puce (20, 20a) comprenant une première couche d'oxyde (21) et des premières interconnexions métalliques (22) débouchant sur une face (210) de la première couche d'oxyde (21), dite première face avant (210), le substrat (10, 10a) comprenant une deuxième couche d'oxyde (11) et des deuxièmes interconnexions métalliques (12) débouchant sur une face (110) de la deuxième couche d'oxyde (11), dite deuxième face avant (110), le substrat (10, 10a) et la puce (20, 20a) étant assemblés par collage au niveau des première et deuxième faces avant (210, 110), le dispositif comprenant en outre :
• une couche d'encapsulation (31) s'étendant sur la deuxième face avant (110), et sur une première face arrière (220) de la puce (20, 20a) opposée à la première face avant (210), ladite couche d'encapsulation (31) présentant une face (310) plane, dite face de manipulation (310),
• une plaque (40) dite de manipulation sur la face de manipulation (310),
• des vias de connexion (50) traversant le substrat (10, 10a) depuis une deuxième face arrière (120) opposée à la deuxième face avant (110), lesdits vias de connexion (50) étant connectés aux deuxièmes interconnexions métalliques (12),
le dispositif étant **caractérisé en ce que** le substrat (10, 10a) comprend une couche semiconductrice (13, 133) **en ce que** les vias de connexion (50) traversent ladite couche semiconductrice (13, 133), et **en ce que** le pas minimal entre les vias de connexion (50) est de l'ordre de 5 µm.

15. Dispositif selon la revendication précédente dans lequel les vias de connexion (50) sont connectés à une couche (90) de circuit intégré comprenant des transistors complémentaires métal-oxyde-semiconducteur.

16. Dispositif selon la revendication 14 dans lequel les vias de connexion (50) sont connectés à une couche (90) de photonique sur silicium soit reportée soit directement formée sur les vias (50).
